# EUROPEAN PATENT APPLICATION

(11) **EP 4 770 315 A1**
(43) Date of publication of application: **01.07.2026**
(21) Application number: 25214306.0
(22) Date of filing: 07.11.2025
(51) Int. Cl.: H10D 30/00, H10W 10/00, H10W 10/17, H10D 84/01, H10D 84/83, H10D 84/03

(54) **SELF-ALIGNED METAL GATE CUT FOR YIELD IMPROVEMENT**

(30) Priority: 26.12.2024 US 202419002341
(71) Applicant: Intel Corporation, Santa Clara, CA 95054 (US)
(72) Inventor: Zhang, Kan, Hillsboro OR, 97123 (US); Chu, Tao, Portland OR, 97229 (US); Xu, Guowei, Portland OR, 97229 (US); Zhang, Yang, Rio Rancho NM, 87124 (US); Hung, Ting-Hsiang, Beaverton OR, 97007 (US); Zhang, Feng, Portland OR, 97229 (US); Lin, Chia-Ching, Portland OR, 97229 (US); Yeung, Chun Wing, Portland OR, 97229 (US); Lu, Yuanfang, Hillsboro OR, 97123 (US); Luo, Yanbin, Portland OR, 97229 (US); Lin, Chung-Hsun, Portland OR, 97229 (US); Ghani, Tahir, Portland OR, 97229 (US)
(74) Representative: Samson & Partner Patentanwälte mbB

(57) **Abstract**

Integrated circuit (IC) devices having isolation structures in metal gate cuts. An IC device may include first and second source-drain contacts in first and second transistor structures over a substrate, and a dielectric structure having first and second feet extending into the substrate, between the first and second source or drain contacts, and with a portion of the substrate between the first and second feet. The first and second feet may each have a width approximately equal to a gate length. The portion of the substrate between the first and second feet of the dielectric structure has a width approximately equal to a distance between adjacent gate electrodes. The dielectric structure may be formed in a gate cut by a self-aligned etch following a selective recess of source-drain contacts.

## Description

### BACKGROUND

In the continuing effort to scale down integrated circuit (IC) devices, the patterning required to form small device features faces new difficulties. For example, as gate electrodes and adjacent source-drain contacts are brought ever more closely together, metal gate cuts are more likely to cause damage to the nearby contacts. Besides damage from gate cuts, etched-away patterning residue may cause shorts between source-drain and gate interconnects, e.g., in SRAM (static random-access memory) bitcells.

New techniques, structures, and materials are needed to improve gate cuts and isolation structures between gate electrodes and source-drain contacts.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIGS. 1A, 1B, 1C, and 1D illustrate cross-sectional profile and plan views of an integrated circuit (IC) device having an isolation structure separated from source or drain contacts in source and drain trenches by dielectric layers, in accordance with some embodiments;
FIGS. 2A and 2B illustrate cross-sectional profile views of an IC device having an isolation structure separated from source or drain contacts in source and drain trenches by dielectric layers, in accordance with some embodiments;
FIG. 3 is a flow chart of methods for forming a well-confined isolation structure through or between metal gate electrodes without damaging adjacent source or drain contacts, in accordance with some embodiments;
FIGS. 4A, 4B, 4C, 4D, and 4E illustrate cross-sectional profile views of an IC device having an isolation structure separated from source or drain contacts by dielectric layers in source and drain trenches, at various stages of manufacture, in accordance with some embodiments;
FIG. 5 illustrates a diagram of an example data server machine employing an IC device having an isolation structure separated from source or drain contacts by multiple dielectric layers, in accordance with some embodiments; and
FIG. 6 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicate that two or more elements are in either direct or indirect (with other intervening elements between them) physical or electrical contact with each other, and/or that the two or more elements co-operate or interact with each other (e.g., as in a cause-and-effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Structures, materials, and techniques are disclosed to improve gate cuts and isolation structures between gate electrodes and source-drain contacts in integrated circuit (IC) devices.

Employing a self-aligned metal-gate cut may confine the gate cut and not protrude into the source-drain region. The well-confined gate cut may eliminate or reduce shorting faults between gate electrodes and source-drain contacts. This self-aligned gate cut will not damage source-drain trench features and removes the need to re-connect cut source-drain contacts.

Source and drain contacts may be selectively recessed, and hardmasks may be deposited over the recessed contacts. A patterned hardmask may be used with the self-aligned hardmask to etch through the gate metal without cutting into the source-drain trench. The self-aligned hardmask may confine the gate cut and protect the source-drain contacts.

The gate cut may have a detectably unorthodox etch-front, and the resultant gate-cut structure may reveal the etching means. A selective gate etch may cause deeper feet or pedestals where the etch more quickly removes the metal gates and a retained portion of the substrate between the pedestals where the source-drain trench inhibits the etch.

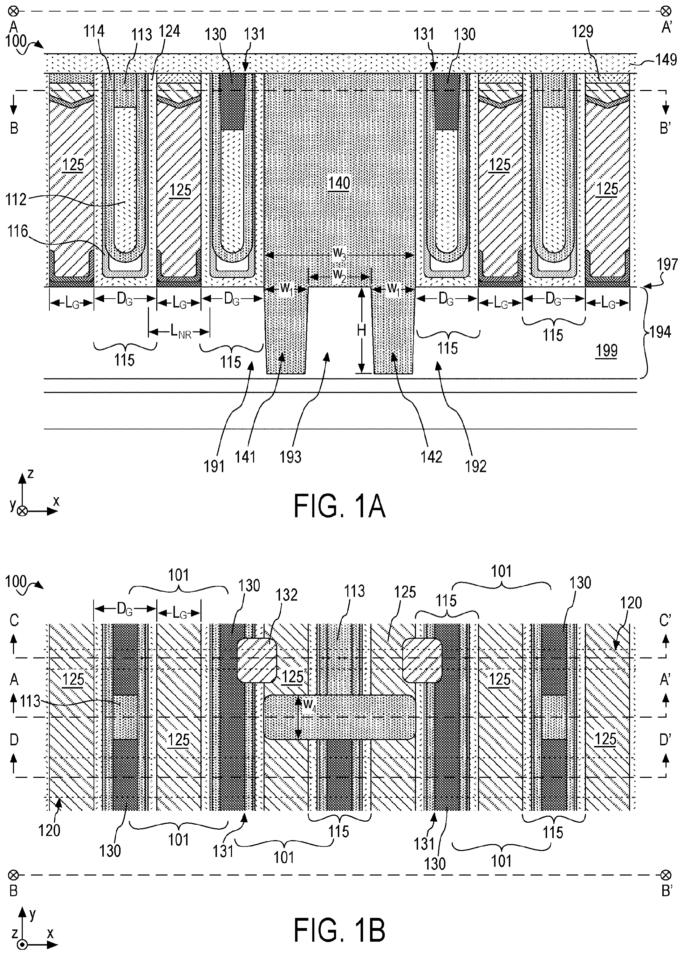

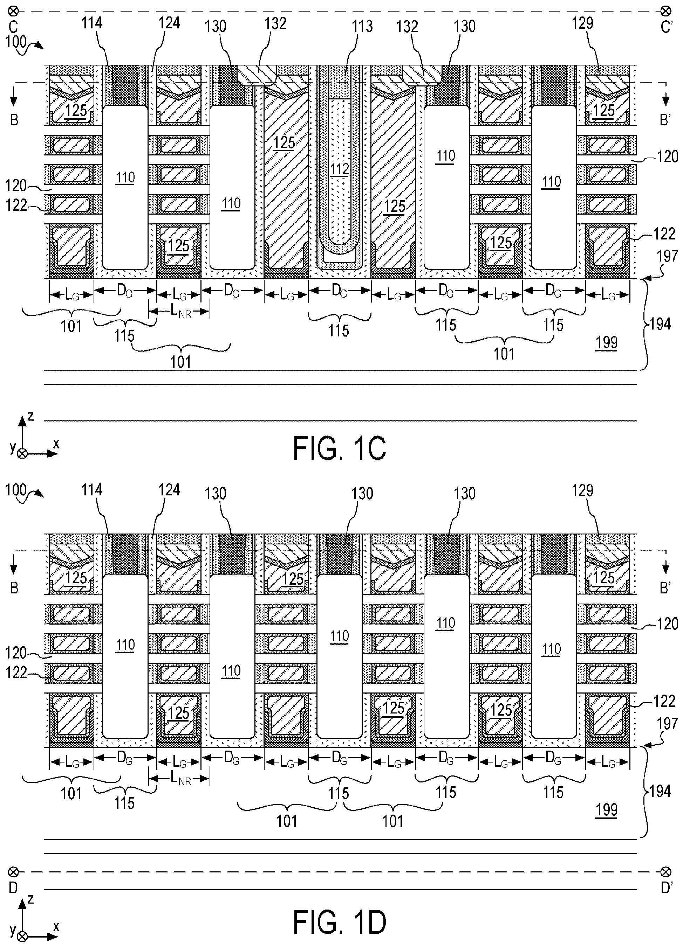

FIGS. 1A, 1B, 1C, and 1D illustrate cross-sectional profile and plan views of an IC device 100 having an isolation structure 140 separated from source or drain contacts 130 in source and drain trenches 115 by dielectric layers 114, 116, 124, in accordance with some embodiments. FIGS. 1A and 1B show dielectric structure 140, which is between the transistor structures 101 illustrated in FIGS. 1C and 1D, for example, separating the gate electrodes 125 of FIGS. 1C, 1D. Apparatus or device 100 is aligned on a consistent x-axis throughout FIGS. 1A-1D, e.g., with a same source or drain contact 130 extending in the y-directions seen in FIGS. 1C and 1D aligned on source or drain bodies 110 and in FIGS. 1A and 1B aligned over or between bodies 110 in viewing planes C-C' and D-D' of FIGS. 1C and 1D.

FIG. 1A shows an x-z profile view of dielectric structure 140 extending between source or drain contacts 130 and trenches 115 without protruding into trenches 115. FIG. 1B illustrates an x-y plan view of dielectric structure 140 between source or drain contacts 130 and separating gate electrodes 125 in adjacent transistor structures 101 over parallel channels (e.g., nanoribbons 120). FIGS. 1C and 1D show x-z profile views of the separated electrodes 125 over nanoribbons 120 in transistor structures 101 to both sides (e.g., in the y-directions) of dielectric structure 140, including source or drain contacts 130 coupling transistor structures 101 to the both sides. The orientations of x-z viewing planes A-A', C-C', and D-D' of FIGS. 1A, 1C, and 1D, respectively, are illustrated in the x-y viewing plane B-B' of FIG. 1B. The orientation of plane B-B' of FIG. 1B is shown in FIGS. 1A, 1C, and 1D, e.g., through contacts 130 and upper portions of gate electrodes 125.

As illustrated in FIG. 1A, isolation structure 140 is between first and second source or drain contacts 130. Isolation structure 140 extends down into the substrate 199, between first and second portions 191, 192 of substrate 199. Isolation structure 140 is over a third portion 193 of substrate 199. Isolation structure 140 includes first and second pedestals 141, 142. Pedestals 141, 142 extend below gate electrodes 125 (which are parts of transistor structures 101 shown further at FIGS. 1B-1D) into substrate 199. First pedestal 141 is adjacent first portion 191 of substrate 199. Second pedestal 142 is adjacent second portion 192 of substrate 199. Pedestals 141, 142 are feet (or legs, stanchions, etc.) of structure 140, e.g., at a bottom of structure 140. A third portion 193 of substrate 199 is between pedestals 141, 142. Pedestal 141 is between first and third portions 191, 193 of substrate 199. Pedestal 142 is between second and third portions 192, 193 of substrate 199.

Isolation structure 140 is a dielectric structure that provides electrical isolation between adjacent structures, such as gate electrodes 125 and source and drain contacts 130. Structure 140 includes any suitable (e.g., dielectric) material(s). Isolation structure 140 advantageously includes a low-permittivity ("low-k") dielectric material. Isolation structure 140 advantageously has etch selectivities with adjacent dielectric and other structures (for example, of silicon and oxides). In many embodiments, structure 140 includes silicon and nitrogen (e.g., in a silicon nitride). In some embodiments, structure 140 includes silicon and oxygen (e.g., in a silicon oxide).

Both source and drain contacts 130 in FIG. 1A extend in both y-directions and contact source or drain bodies 110 in both FIGS. 1C and 1D. Both contacts 130 in FIG. 1A couple a body 110 in a structure 101 in FIG. 1C with a body 110 in a structure 101 in FIG. 1D. Contacts 130 are metallization structures that couple (e.g., electrically couple) bodies 110 (e.g., as illustrated at FIGS. 1C and 1D), for example, with an interconnect network (not shown) above transistor structures 101. Contacts 130 may include any suitable material(s), e.g., conductive materials (such as metals or non-metals). For example, contacts 130 may include an interface (e.g., silicide) layer on bodies 110. Contacts 130 may include multiple layers of metals, for example, a liner (e.g., barrier or seed) layer around a fill layer. In many embodiments, contacts 130 include tungsten. In some embodiments, contacts 130 include one or more of copper, gold, tantalum, cobalt, tungsten, ruthenium, molybdenum, aluminum, and nickel, including in alloys. In some embodiments, contacts 130 include nitrides of metals, e.g., tantalum and titanium.

Source and drain contacts 130 are in source and drain trenches 115. As described, contacts 130 in FIG. 1A contact source or drain bodies 110 in FIGS. 1C and 1D. Viewing plane A-A' of FIG. 1A is through multiple dielectric materials (e.g., layers 114, 116, 124) in trenches 115. Spacer layers 124 conformally line trenches 115, e.g., containing other dielectrics within liner layers 124. In some embodiments, liner layers 116 are on layers 124. Trench fill 112 is within liner layers 114, and dielectric cap 113 is over fill 112 and within layers 114. In trenches 115 without contacts 130 in plane A-A' of FIG. 1A, plane A-A' of FIG. 1A is through a dielectric cap 113 in trench 115. Advantageously, the dielectric materials (e.g., layers 114, 116, 124) in trenches 115 have etch selectivities. In many embodiments, dielectric fill 112 is of a low-k dielectric material (e.g., including silicon and oxygen). In many embodiments, dielectric cap 113 and layer 114 have an etch selectivity with fill 112, e.g., both including silicon and nitrogen. In some embodiments, layers 116, 124 have etch selectivities with layer 114, e.g., both including include silicon (e.g., 50% or more) and one or both of carbon and oxygen (e.g., > 15%), but do not include appreciable amounts of nitrogen (e.g., a negligible or non-detectable amount of nitrogen, such as < 5%).

The dielectric materials in trenches 115 provide electrical isolation between adjacent bodies 110 (e.g., in the y-directions) and between gate electrodes 125 (e.g., in the x-directions). Trenches 115 have a width in the x-directions of distance D_{G}, which separates adjacent electrodes 125. Gate electrodes 125 have a length L_{G}, which separates adjacent trenches 115 (e.g., length L_{G} is between spacer layers 124 of adjacent trenches 115). Length L_{NR}, longer than length L_{G}, is the span of nanoribbons 120 (e.g., as shown at FIGS. 1C and 1D) between source and drain bodies 110 (e.g., through electrodes 125 and a spacer layer 124 on each side of electrode 125).

First and second pedestals 141, 142 both have widths w₁. First pedestal 141 has width w₁ between first and third portions 191, 193 of substrate 199. Second pedestal 142 has width w₁ between second and third portions 192, 193 of substrate 199. Width w₁ is approximately equal to length L_{G} of electrode 125 adjacent first contact 130 (e.g., with first contact 130 between the electrode 125 and dielectric structure 140).

Third portion 193 of substrate 199 has a width w₂ approximately equal to distance D_{G}, the distance D_{G} separating adjacent gate electrodes 125. Adjacent electrodes 125 are, e.g., on a same side of dielectric structure 140, with a first electrode 125 adjacent structure 140 and between structure 140 and a nearest, second electrode 125. In many embodiments, third portion 193 of substrate 199 has a height H approximately equal to a depth of first pedestal 141 (which is also equal to a depth of second pedestal 142).

Isolation structure 140 is between trenches 115. One or more dielectric layers (e.g., layers 114, 116, 124) are between dielectric structure 140 and a sidewall 131 of first source or drain contact 130 (e.g., in the negative x-direction). One or more dielectric layers (e.g., layers 114, 116, 124) are between dielectric structure 140 and sidewall 131 of second source or drain contact 130 (e.g., in the positive x-direction). Isolation structure 140 has a width w₃ (e.g., in the x-directions) between the one or more dielectric layers (e.g., layers 114, 116, 124) on each of the opposing sidewalls 131. In many embodiments, width w₃ of structure 140 is approximately equal to a sum of distance D_{G} (between adjacent electrodes 125) and twice length L_{G} (between adjacent trenches 115). No section of either source or drain contact 130 overhangs any section of dielectric structure 140. (Contacts 130 may be coupled with metallization lines (not show) that are routed over dielectric structure 140, but no section of either source or drain contact 130 (e.g., with an upper surface coplanar with structure 140; under layer 149) overhangs any section of dielectric structure 140.

Isolation structure 140 is between trenches 115 to both sides (e.g., in the x-directions), and an adjacent gate electrode 125 is to both sides with a trench width between structure 140 and each electrode 125. The distance D_{G} (between adjacent electrodes 125) separates dielectric structure 140 and each adjacent gate electrode 125.

Gate electrodes 125 may include one or more metal layers. Electrodes 125 may electrostatically control the conduction of transistor structures 101, for example, through gate dielectric layer 122 (as described at least FIG. 1C). Gate electrodes 125 may include workfunction metal (WFM) layers, e.g., to (e.g., independently) influence threshold voltages V_{T} of transistor structures 101. Fill layers in electrodes 125 may have different material compositions than liner layers. Layers of electrode 125 may include any suitable material(s), including non-metals. In many embodiments, electrode 125 layers include nitrogen (e.g., in a metal nitride) or carbon (e.g., in a metal carbide). In some such embodiments, electrode 125 layers include nitrogen and titanium, molybdenum, or tantalum. In some embodiments, a first electrode 125 layer includes titanium and nitrogen, and a second electrode 125 layer on the first electrode 125 layer includes tantalum and nitrogen and tantalum or molybdenum. In some embodiments, electrode 125 layer includes titanium, aluminum, and carbon. In many embodiments, electrode 125 fill layer includes tungsten. An isolation layer 129 may be over electrodes 125, and electrodes 125 may be contacted through layer 129 by (e.g., and coupled with) a gate via (not shown) and, for example, with an interconnect network (not shown) above transistor structures 101.

A dielectric layer 149 is over contacts 130 and transistor structures 101 (as described further at, e.g., FIGS. 1B-1D). Dielectric layer 149 may be of any suitable material, such as a low-k dielectric material (for example, including silicon and oxygen).

Substrate 199 may include any suitable material or materials. Substrate 199 may be an IC substrate, such as an IC die or wafer. In some examples, the substrate may include monocrystalline silicon (including silicon on insulator (SOI)), polycrystalline silicon, germanium, silicon germanium, a III-V alloy material (e.g., gallium arsenide), a silicon carbide (e.g., SiC), a sapphire (e.g., Al₂O₃), or any combination thereof. Substrate 199 may also include semiconductor materials, metals, dielectrics, dopants, and other materials commonly found in semiconductor substrates. Substrate 199 may refer specifically to a base material (for example, a thick base or layer of semiconductor material) that other materials (such as metals and dielectrics) are built up on. In some contexts, substrate 199 may refer to a base material layer and any build-up layers, etc., over the base.

In the exemplary embodiment of FIG. 1A, substrate 199 includes (at least) a layer 194 of semiconductor material, for example, of monocrystalline silicon, etc. Transistor structures 101 (as illustrated further at, e.g., FIGS. 1C and 1D) are on or over an upper surface 197 of layer 194 of substrate 199. Isolation structure 140 extends into layer 194 of semiconductor material, and third portion 193 of substrate 199 is at least predominantly semiconductor material between pedestals 141, 142 of dielectric structure 140.

FIG. 1B shows dielectric structure 140 between source or drain contacts 130 and separating gate electrodes 125 in adjacent transistor structures 101 over parallel stacks of nanoribbons 120. Possible edges or borders of nanoribbons 120 are indicated by dotted lines, but nanoribbons 120 are not necessarily populated at all possible locations. For example, a dielectric cap 113 is adjacent dielectric structure 140 in a trench 115 that nanoribbons 120 do not extend to, e.g., without a source or drain body 110 (as described further at FIG. 1C).

Electrodes 125 extend in the y-directions and, in some cases, a single electrode 125 is over nanoribbons 120 in both viewing planes C-C' and D-D'. Source or drain contacts 130 extend in the y-directions and, in some cases, a single contact 130 is over source or drain bodies 110 in both viewing planes C-C' and D-D'. As described at FIG. 1A, dielectric caps 113 are in some trenches 115 and separate contacts 130 that are on bodies 110 in viewing planes C-C' and D-D' but do not couple the bodies 110 through viewing plane A-A' of FIG. 1A.

As described at FIG. 1A, dielectric structure 140 is between (e.g., in the x-directions) a pair of trenches 115 and corresponding source or drain contacts 130 spanning between and contacting (e.g., and coupling) source or drain bodies 110 in viewing planes C-C' and D-D'. Isolation structure 140 separates electrodes 125 over single stacks of nanoribbons 120 in one or the other of viewing planes C-C' and D-D' (e.g., not coupling the transistor structures 101 at electrodes 125 through viewing plane A-A' of FIG. 1A). Dielectric structure 140 has a width w₄ in the y-directions. In many embodiments, width w₄ of structure 140 is approximately equal to distance D_{G} (between adjacent electrodes 125).

Some of contacts 130 and electrodes 125 may be coupled by interconnect links 132. Links 132 may be metallization structures that electrically couple contacts 130 and electrodes 125 (e.g., through layers 114, 116, 124). Links 132 do not contact dielectric structure 140 and, separated from structure 140 by electrode 125, etc., links 132 do not overhang structure 140.

FIG. 1C illustrates transistor structures 101 with nanoribbon 120 channel regions extending through gate electrodes 125 and between source and drain bodies 110. Gate dielectric layer 122 is on nanoribbons 120, insulating between nanoribbons 120 and gate electrodes 125. Gate dielectric layer 122 may be a high-k dielectric material, e.g., to electrostatically control the conduction of transistor structures 101 while minimize gate leakage. Bodies 110 are in trenches 115 with spacer layers 124 between electrodes 125 and bodies 110. Nanoribbons 120 extend through layers 124. Bottoms of transistor structures 101 are on or over upper surface 197 of layer 194. Links 132 couple some source and drain contacts 130 and gate electrodes 125. Dielectric cap 113 is over a trench 115 without a body 110.

Source and drain bodies 110 are electrically and physically coupled to ends of nanoribbons 120 (e.g., channel regions). Source or drain bodies 110 may be impurity doped bodies, e.g., regions of semiconductor material doped with one or more electrically active impurities and having increased charge-carrier availabilities and associated conductivities. Bodies 110 in different transistor structures 101 may be doped with an opposite type (e.g., n- or p-type) or of similar type. Source or drain bodies 110 may include a predominant semiconductor material, and one or more n-dopants (such as phosphorus, arsenic, or antimony) or p-type impurities (such as boron or aluminum). Other dopant materials may be used. Any suitable means of formation may be used. Bodies 110 may be epitaxially grown semiconductor regions, for example, of a Group IV semiconductor material (e.g., Si, Ge, SiGe, GeSn alloy). Other semiconductor materials may be employed. Bodies 110 may be substantially crystalline. Source or drain bodies 110 may be polycrystalline or substantially monocrystalline, e.g., having long-range order at least adjacent ends of nanoribbons 120 (e.g., to both sides of bodies 110) and merging or joining into a unitary body with few grain boundaries.

Nanoribbons 120 are semiconductor structures electrically coupled between source and drain bodies 110. In many embodiments, transistor structures 101 are each physically symmetrical about nanoribbon 120 channel regions and gate electrodes 125, and identifiers "drain" and "source" for bodies 110 may be reversed interchangeably in many contexts. However, the classification of source or drain bodies 110 may be by the electrical relationships of transistor structures 101 and bodies 110 to other components in a given circuit (e.g., and the consequent direction of current flow through structures 101 and bodies 110). Some source or drain bodies 110 may simultaneously be a source body 110 in one transistor structure 101 and a drain body 110 in another transistor structure 101.

FIG. 1D shows transistor structures 101 with nanoribbon 120 channel regions extending through gate electrodes 125 and between source and drain bodies 110, similarly to FIG. 1C. Notably, all trenches 115 include a body 110 coupled with nanoribbons 120 and coupled with a contact 130. No dielectric cap 113 replaces a contact 130.

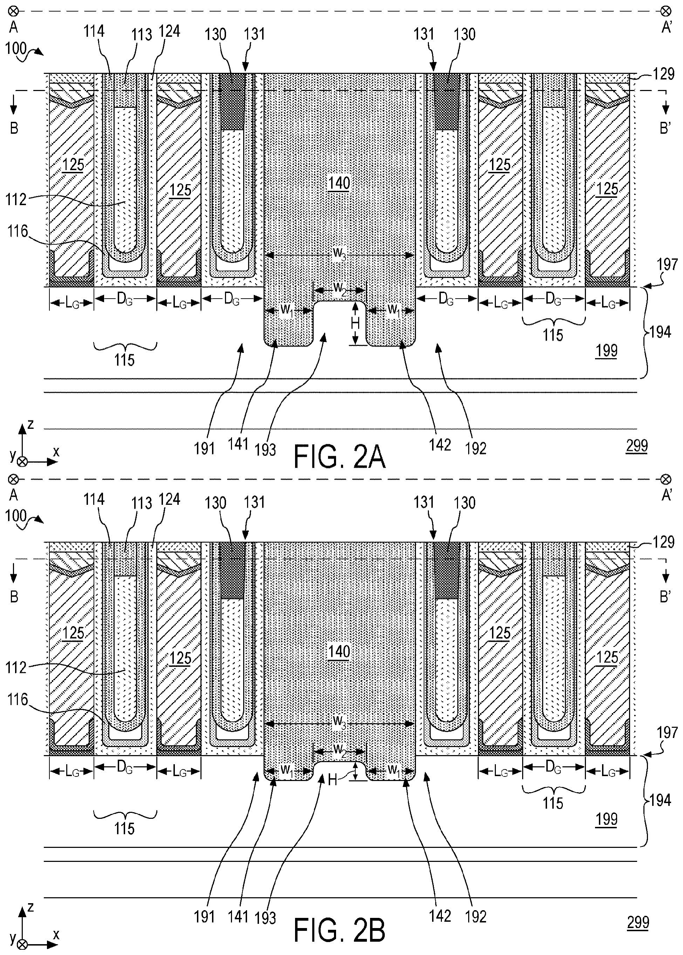

FIGS. 2A and 2B illustrate cross-sectional profile views of an IC device 100 having isolation structure 140 separated from source or drain contacts 130 in source and drain trenches 115 by dielectric layers 114, 116, 124, in accordance with some embodiments. FIGS. 2A and 2B show embodiments of isolation structure 140 with smaller (e.g., less deep) pedestals 141, 142.

FIG. 2A illustrates third portion 193 of substrate 199 with a shorter height H than depths of pedestals 141, 142. Height H of third portion 193 does not reach up to upper surface 197 of layer 194 of substrate 199. Height H may be defined from a bottom of pedestals 141, 142. A depth of pedestals 141, 142 may be defined from a bottom of pedestals 141, 142 to surface 197, where layer 194 meets spacer layer 124 of trenches 115. Dielectric structure 140 may have different characteristics (e.g., depths, proportions, etc.) based on various etch characteristics (such as etch selectivities, overetch, etc.).

IC device 100 may include or be coupled to a substrate or other host component 299. Host component 299 may be a package substrate, an interposer, an IC die, etc. For example, substrate 199 may be an IC die that includes transistor structures 101, substrate 199 may be coupled (e.g., soldered or otherwise bonded) to host component 299, and transistor structures 101 may be coupled to a power supply (not shown) through host component 299.

Host component 299 is a planar platform and may include dielectric and metallization structures. Host component 299 mechanically supports and electrically couples one or more IC devices 100. At least one side of host component 299 includes substrate interconnect interfaces for bonding to one or more IC devices 100. IC device 100 may be direct bonded, e.g., hybrid bonded, to host component 299 or otherwise bonded, e.g., by optional solder bumps. The opposite side of host component 299 may include similar interfaces, e.g., copper pads for socketing and/or solder bumps for bonding device 100 to a host component, such as a printed circuit board (PCB). Host component 299 may be any host component with substrate interconnect interfaces, such as a package host component 299 or interposer, etc. Host component 299 may itself be a die. In many embodiments, host component 299 includes organic dielectric(s), such as a resin or other polymer, between metallization layers.

FIG. 2B shows a yet shorter third portion 193 and shallower pedestals 141, 142, for example, due to a less selective etch and smaller overetch. Widths w₁ of pedestals 141, 142 may be defined between sidewalls halfway between a bottom of pedestals 141, 142 to a top of portion 193.

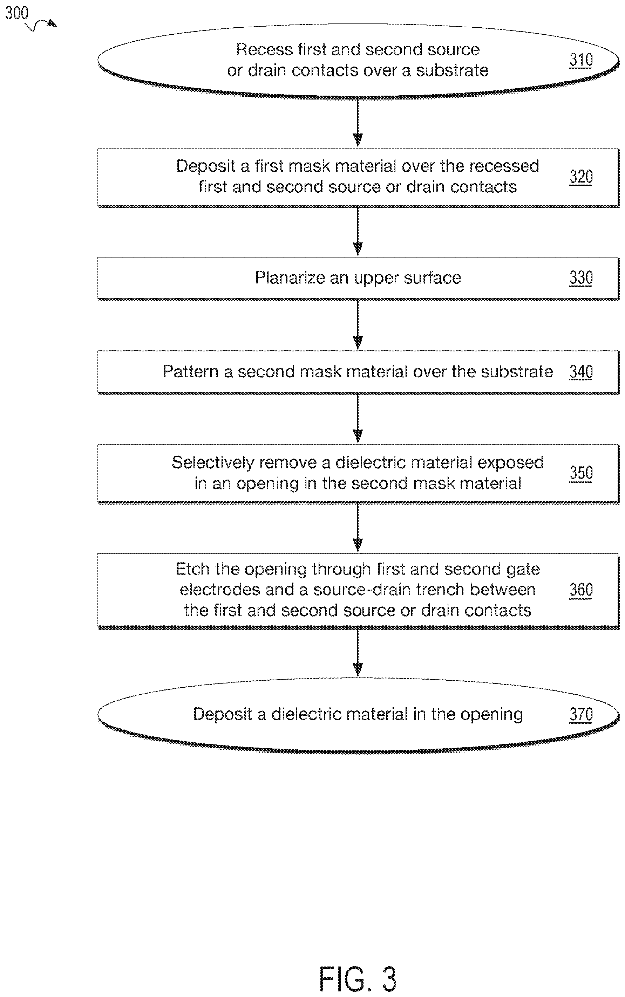

FIG. 3 is a flow chart of methods 300 for forming a well-confined isolation structure through or between metal gate electrodes without damaging adjacent source or drain contacts, in accordance with some embodiments. Methods 300 include operations 310-370. Some operations shown in FIG. 3 are optional. Additional operations may be included. FIG. 3 shows an example sequence, but the operations can be done in other orders as well, and some operations may be omitted. Some operations can also be performed multiple times before other operations are performed. For example, upper surfaces may be planarized multiple times before dielectric material is deposited. Some operations may be included within other operations so that the number of operations illustrated FIG. 3 is not a limitation of the methods 300.

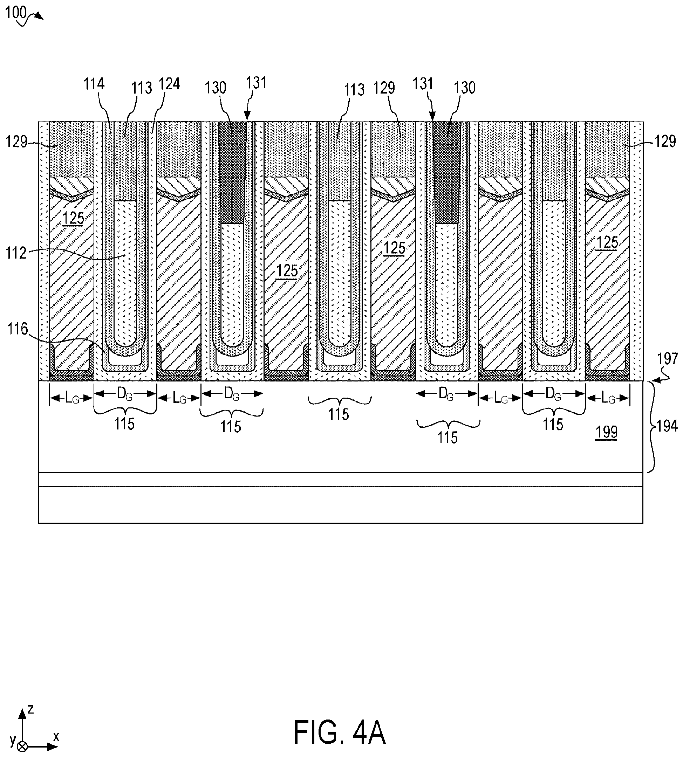

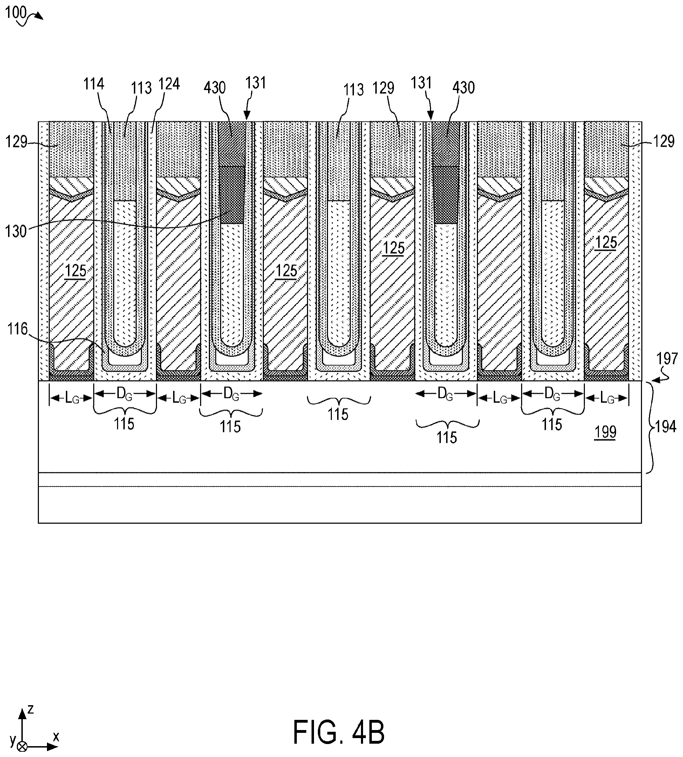

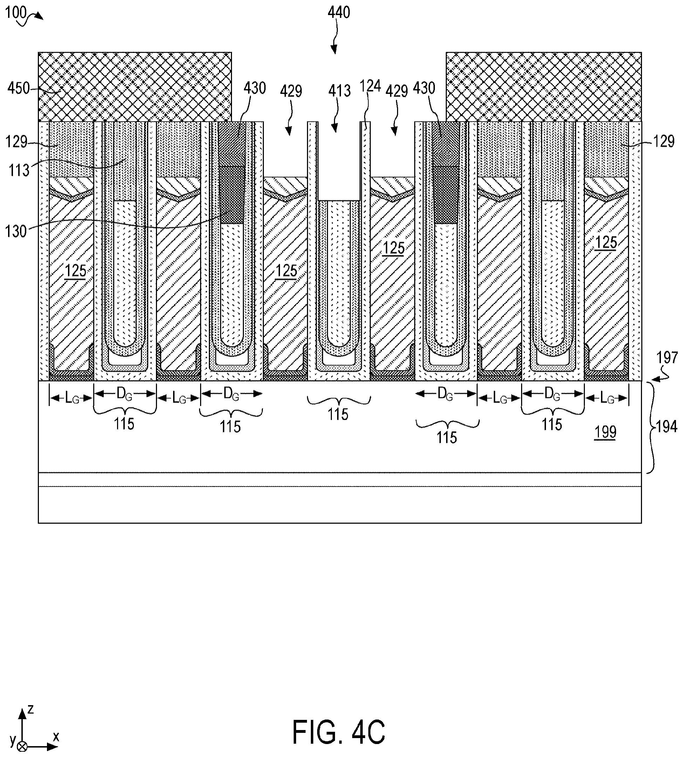

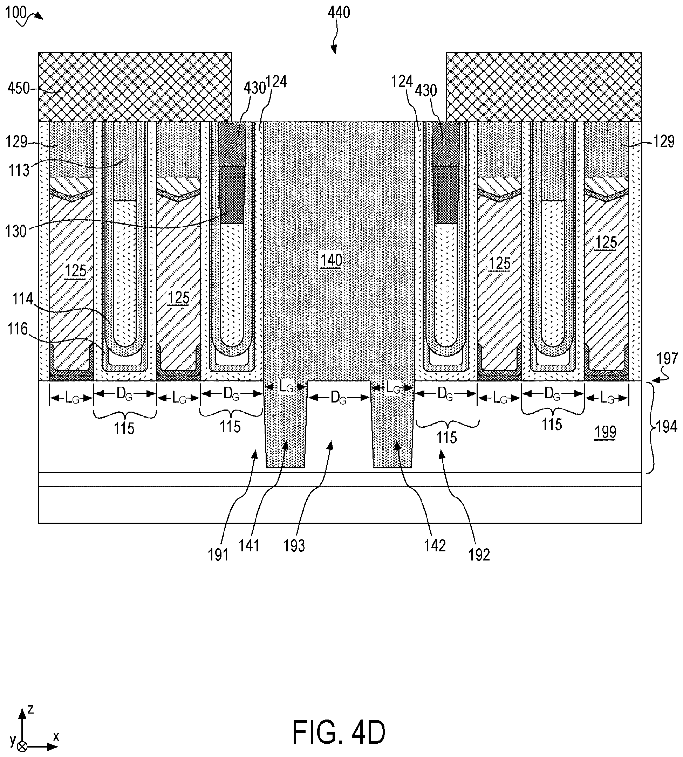

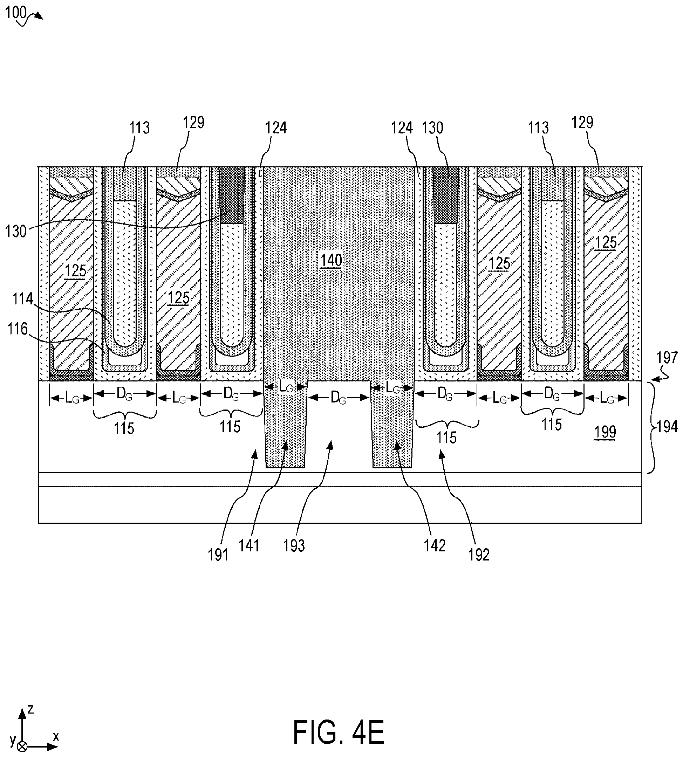

FIGS. 4A, 4B, 4C, 4D, and 4E illustrate cross-sectional profile views of an IC device having an isolation structure 140 separated from source or drain contacts 130 by dielectric layers 114, 116, 124 in source and drain trenches 115, at various stages of manufacture, in accordance with some embodiments. FIGS. 4A-4E show possible examples of intermediate structures during an embodiment of a practice of methods 300 of FIG. 3.

FIG. 4A shows gate electrodes 125 between source or drain contacts 130 in a workpiece or IC device 100, in accordance with some embodiments, for example, before a performance of recessing operation 310. Contacts 130 may have etch selectivities with exposed dielectric caps 113 and layers 129. In many embodiments, contacts 130 are predominantly tungsten, and caps 113 and layers 129 include silicon and nitrogen. Gate electrodes 125 between sidewalls 131 of source or drain contacts 130 may be removed by methods 300, while contacts 130 are protected.

Returning to FIG. 3, methods 300 begin at operation 310 with recessing first and second source or drain contacts over a substrate. First and second gate electrodes may be between the first and second source or drain contacts, and a source or drain trench may be between the first and second gate electrodes. For example, the first and second source or drain contacts may form the outer edges of an etched opening that will include the first and second gate electrodes and the source or drain trench.

The first and second source or drain contacts, first and second gate electrodes, and the source or drain trench may be received on or in a substrate, such as an IC die or wafer, e.g., much as described of substrate 199 at FIG. 1A. The first and second source or drain contacts may be recessed by any suitable means. In many embodiments, the first and second source or drain contacts are recessed by a selective etch, for example, that selectively removes a metal of the contact structures and retains exposed dielectric layers over gate electrodes and non-contacted source-drain trenches. In preparation for recessing operation 310, a process flow may be altered to increase a thickness of source or drain contacts, which may allow for both sufficient recessing (and subsequent self-aligned mask thickness, following operation 320) and sufficient contact size following recessing.

Returning to FIG. 3, methods 300 continue by depositing a (first) mask material over the recessed first and second source or drain contacts at operation 320. The first mask material may be deposited by any suitable means, for example, by a CVD (chemical vapor deposition) or an atomic layer deposition (ALD). The first mask material may be or include any suitable material(s). Advantageously, the first mask material has etch selectivities with exposed structures of the substrate. In many embodiments, exposed dielectrics include silicon and nitrogen, and the deposited first mask material includes silicon and carbon (e.g., in a carbide of silicon).

Returning to FIG. 3, methods 300 continue at operation 330 with planarizing an upper surface of the substrate. The planarizing may remove excess mask material and may expose or reveal dielectrics, etc., to be subsequently removed. The planarizing may be by any suitable means, for example, a CMP (chemical-mechanical planarization or polish). The planarizing may leave the substrate with self-aligned masks (of the first mask material) only over the recessed source or drain contacts.

FIG. 4B illustrates hardmasks 430 over source or drain contacts 130 in workpiece or device 100, in accordance with some embodiments, for example, following a performance of recessing, depositing, and planarizing operations 310, 320, and 330. Excess mask material has been removed over substrate 199, leaving only (planarized) hardmasks 430 over recessed source or drain contacts 130.

Returning to FIG. 3, methods 300 continue with patterning a second mask material over the substrate at operation 340. The patterning the second mask material may provide an opening in the second mask material over the first and second gate electrodes, the source or drain trench, and first and second portions of the first mask material. For example, the opening may comfortably leave exposed the first and second gate electrodes and the source or drain trench (or at least the dielectrics over the first and second gate electrodes and the source or drain trench). The second mask material may partially cover portions of the first mask material (and leave exposed other portions of the first mask material). The self-aligned first mask material may provide patterning margin (e.g., for alignment errors) and ensure that the mask opening does not leave unprotected any outer source or drain trenches (e.g., outside of the first and second gate electrodes). The patterning may be by any suitable means, for example, a photolithography operation. The second mask material may be any suitable material(s), such as a carbon hard mask, which may enable a selective etch that works well with the first mask material.

Returning to FIG. 3, methods 300 continue at operation 350 by selectively removing an exposed dielectric material in the opening (e.g., over the first and second gate electrodes and the source or drain trench). Removing the exposed dielectric material over the first and second gate electrodes and the source or drain trench may lessen the requirements (e.g., duration or power) of a subsequent etch (e.g., an anisotropic etch through the gate electrodes to the underlying substrate). The selective removal of the exposed dielectric material in the opening may be enabled by the self-aligned (first) and patterned (second) mask materials, which may have etch selectivities with the exposed dielectrics of the substrate. The selective removal may be by any suitable means, for example, an isotropic etch of any exposed dielectric caps and layers. In many embodiments, exposed dielectrics of the substrate (e.g., in the opening, over the first and second gate electrodes and the source or drain trench) include silicon and nitrogen. In many embodiments, the first and second mask materials include carbon.

FIG. 4C shows opening 440 in hardmask layer 450 in workpiece or device 100, in accordance with some embodiments, for example, following a performance of patterning and removing operations 340 and 350. Hardmask layer 450 is over substrate 199, and opening 440 is over first and second gate electrodes 125 and source or drain trench 115. Hardmasks 430 bracket first and second gate electrodes 125 and source or drain trench 115 and may protect contacts 130, while acting in concert with hardmask layer 450 to direct subsequent etches between hardmasks 430 (and contacts 130). In some embodiments, most or some of spacer layers 124 (etc.) may be retained in opening 440, e.g., between openings 413, 429 (where cap 113 and layers 129 have been removed). In some such embodiments, spacer layers 124 include silicon and oxygen, and cap 113 and layers 129 included silicon and nitrogen.

Returning to FIG. 3, methods 300 continue at operation 360 with etching the opening through the first and second gate electrodes and the source or drain trench. The etching may be by any suitable means, for example, an anisotropic etch down through the mask materials. In many embodiments, the etch is somewhat selective, e.g., preferentially removing the metal of the gate electrodes and more slowly removing the dielectric material of the source or drain trench. In many embodiments, the etch anisotropically etches the opening down into the substrate. In some such embodiments, the etched opening includes first and second portions extending down into the substrate, and a third portion of the substrate is retained between the first and second portions of the opening. In some such embodiments, the first and second portions of the opening each have a width approximately equal to a length of the first gate electrode.

Returning to FIG. 3, methods 300 continue by depositing a dielectric material in the opening at operation 370. The depositing may be by any suitable means, for example, by a CVD. The deposited dielectric material may be any suitable material(s), such as a dielectric material having etch selectivities with adjacent low-k dielectric materials. In many embodiments, the dielectric material comprises silicon and nitrogen. In some embodiments, the dielectric material deposited in the opening at operation 370 has a same composition as the dielectric material selectively removed from over the first and second gate electrodes and the source or drain trench at operation 350. In many embodiments, the dielectric material selectively removed from over the first and second gate electrodes and the source or drain trench is retained over other gate electrodes and source-drain trenches (e.g., under the patterned, second mask material).

In many embodiments, the depositing the dielectric material forms a dielectric structure over the substrate and between the first and second source or drain contacts. In many such embodiments, the dielectric structure includes first and second pedestals, both pedestals have the width (approximately equal to a length of the first gate electrode), and the third portion of the substrate is between the first and second pedestals.

FIG. 4D illustrates isolation structure 140 separated from source or drain contacts 130 by dielectric layers 114, 116, 124 in source and drain trenches 115 in workpiece or device 100, in accordance with some embodiments, for example, following a performance of etching and depositing operations 360 and 370. Contacts 130 in source and drain trenches 115 are not damaged by the gate-cut etch. Self-aligned hardmasks 430 are over source or drain contacts 130. Pedestals 141, 142 have widths equal to length L_{G}. Third portion 193 of substrate 199 is between pedestals 141, 142 and has a width equal to distance D_{G}. In many embodiments, dielectric structure 140 has a same composition as dielectric caps 113 and layers 129 (e.g., still masked by layer 450).

FIG. 4E shows isolation structure 140 separated from source or drain contacts 130 by dielectric layers 114, 116, 124 in source and drain trenches 115 in IC device 100, in accordance with some embodiments, for example, following a performance of planarizing operation 330. Hardmask layer 450 and hardmasks 430 are not present. Source or drain contacts 130 and dielectric caps 113 and layers 129 are exposed.

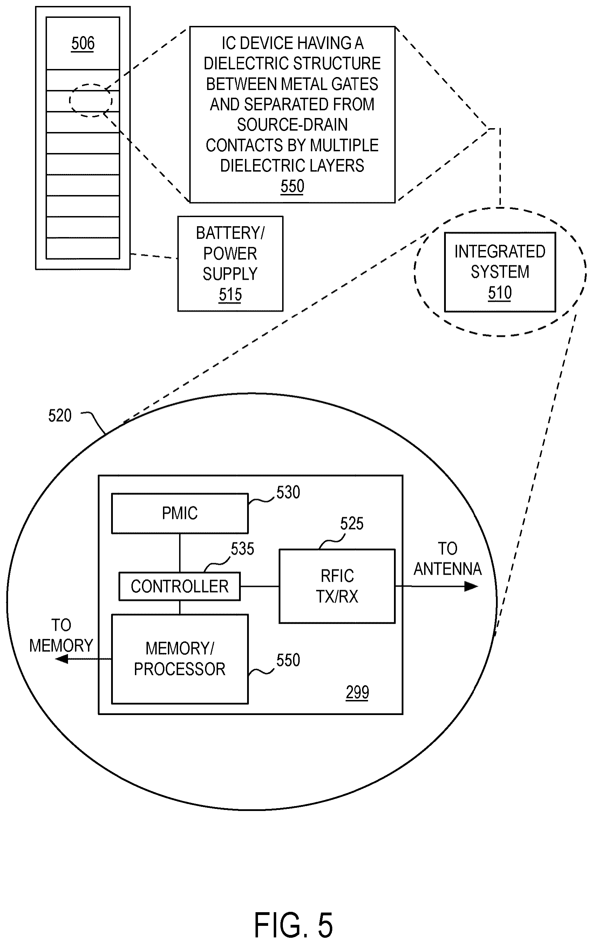

FIG. 5 illustrates a diagram of an example data server machine 506 employing an IC device having an isolation structure separated from source or drain contacts by multiple dielectric layers, in accordance with some embodiments. Server machine 506 may be any commercial server, for example, including any number of high-performance computing platforms disposed within a rack and networked together for electronic data processing, which in the exemplary embodiment includes one or more devices 550 having an isolation structure separated from source or drain contacts by multiple dielectric layers.

Also as shown, server machine 506 includes a battery and/or power supply 515 to provide power to devices 550, and to provide, in some embodiments, power delivery functions such as power regulation. Devices 550 may be deployed as part of a package-level integrated system 510. Integrated system 510 is further illustrated in the expanded view 520. In the exemplary embodiment, devices 550 (labeled "Memory/Processor") includes at least one memory chip (e.g., random-access memory (RAM)), and/or at least one processor chip (e.g., a microprocessor, a multi-core microprocessor, or graphics processor, or the like) having the characteristics discussed herein. In an embodiment, device 550 is a microprocessor including a static RAM (SRAM) cache memory. As shown, device 550 may be an IC device having an isolation structure separated from source or drain contacts by multiple dielectric layers, as discussed herein. Device 550 may be further coupled to (e.g., communicatively coupled to) a board, an interposer, or other substrate or host component 299 along with, one or more of a power management IC (PMIC) 530, RF (wireless) IC (RFIC) 525 including a wideband RF (wireless) transmitter and/or receiver (TX/RX) (e.g., including a digital baseband and an analog front-end module further includes a power amplifier on a transmit path and a low noise amplifier on a receive path), and a controller 535 thereof. In some embodiments, RFIC 525, PMIC 530, controller 535, and device 550 include having an isolation structure separated from source or drain contacts by multiple dielectric layers.

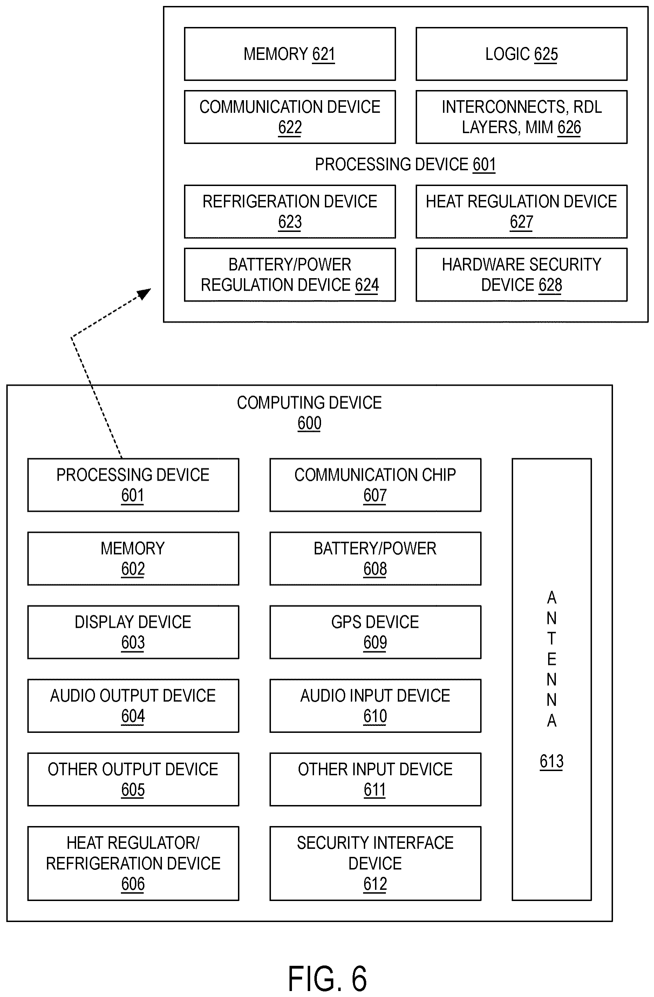

FIG. 6 is a block diagram of an example computing device 600, in accordance with some embodiments. For example, one or more components of computing device 600 may include any of the devices or structures discussed herein. A number of components are illustrated in FIG. 6 as being included in computing device 600, but any one or more of these components may be omitted or duplicated, as suitable for the application. In some embodiments, some or all of the components included in computing device 600 may be attached to one or more printed circuit boards (e.g., a motherboard). In some embodiments, various ones of these components may be fabricated onto a single system-on-a-chip (SoC) die. Additionally, in various embodiments, computing device 600 may not include one or more of the components illustrated in FIG. 6, but computing device 600 may include interface circuitry for coupling to the one or more components. For example, computing device 600 may not include a display device 603, but may include display device interface circuitry (e.g., a connector and driver circuitry) to which display device 603 may be coupled. In another set of examples, computing device 600 may not include an audio output device 604, other output device 605, global positioning system (GPS) device 609, audio input device 610, or other input device 611, but may include audio output device interface circuitry, other output device interface circuitry, GPS device interface circuitry, audio input device interface circuitry, audio input device interface circuitry, to which audio output device 604, other output device 605, GPS device 609, audio input device 610, or other input device 611 may be coupled.

Computing device 600 may include a processing device 601 (e.g., one or more processing devices). As used herein, the term "processing device" or "processor" indicates a device that processes electronic data from registers and/or memory to transform that electronic data into other electronic data that may be stored in registers and/or memory. Processing device 601 may include a memory 621, a communication device 622, a refrigeration device 623, a battery/power regulation device 624, logic 625, interconnects 626 (i.e., optionally including redistribution layers (RDL) or metal-insulator-metal (MIM) devices), a heat regulation device 627, and a hardware security device 628.

Processing device 601 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 600 may include a memory 602, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 602 includes memory that shares a die with processing device 601. This memory may be used as cache memory and may include embedded dynamic random-access memory (eDRAM) or spin transfer torque magnetic random-access memory (STT-MRAM).

Computing device 600 may include a heat regulation/refrigeration device 606. Heat regulation/refrigeration device 606 may maintain processing device 601 (and/or other components of computing device 600) at a predetermined low temperature during operation.

In some embodiments, computing device 600 may include a communication chip 607 (e.g., one or more communication chips). For example, the communication chip 607 may be configured for managing wireless communications for the transfer of data to and from computing device 600. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 607 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 607 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 607 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 607 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 607 may operate in accordance with other wireless protocols in other embodiments. Computing device 600 may include an antenna 613 to facilitate wireless communications and/or to receive other wireless communications (such as AM or FM radio transmissions).

In some embodiments, communication chip 607 may manage wired communications, such as electrical, optical, or any other suitable communication protocols (e.g., the Ethernet). As noted above, communication chip 607 may include multiple communication chips. For instance, a first communication chip 607 may be dedicated to shorter-range wireless communications such as Wi-Fi or Bluetooth, and a second communication chip 607 may be dedicated to longer-range wireless communications such as GPS, EDGE, GPRS, CDMA, WiMAX, LTE, EV-DO, or others. In some embodiments, a first communication chip 607 may be dedicated to wireless communications, and a second communication chip 607 may be dedicated to wired communications.

Computing device 600 may include battery/power circuitry 608. Battery/power circuitry 608 may include one or more energy storage devices (e.g., batteries or capacitors) and/or circuitry for coupling components of computing device 600 to an energy source separate from computing device 600 (e.g., AC line power).

Computing device 600 may include a display device 603 (or corresponding interface circuitry, as discussed above). Display device 603 may include any visual indicators, such as a heads-up display, a computer monitor, a projector, a touchscreen display, a liquid crystal display (LCD), a light-emitting diode display, or a flat panel display, for example.

Computing device 600 may include an audio output device 604 (or corresponding interface circuitry, as discussed above). Audio output device 604 may include any device that generates an audible indicator, such as speakers, headsets, or earbuds, for example.

Computing device 600 may include an audio input device 610 (or corresponding interface circuitry, as discussed above). Audio input device 610 may include any device that generates a signal representative of a sound, such as microphones, microphone arrays, or digital instruments (e.g., instruments having a musical instrument digital interface (MIDI) output).

Computing device 600 may include a GPS device 609 (or corresponding interface circuitry, as discussed above). GPS device 609 may be in communication with a satellite-based system and may receive a location of computing device 600, as known in the art.

Computing device 600 may include other output device 605 (or corresponding interface circuitry, as discussed above). Examples of the other output device 605 may include an audio codec, a video codec, a printer, a wired or wireless transmitter for providing information to other devices, or an additional storage device.

Computing device 600 may include other input device 611 (or corresponding interface circuitry, as discussed above). Examples of the other input device 611 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 600 may include a security interface device 612. Security interface device 612 may include any device that provides security measures for computing device 600 such as intrusion detection, biometric validation, security encode or decode, access list management, malware detection, or spyware detection.

Computing device 600, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1A-6. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, an apparatus includes a first metallization structure on a first source or drain body in a first transistor structure over a substrate, a second metallization structure on a second source or drain body in a second transistor structure over the substrate, and a dielectric structure between the first and second metallization structures and between first and second portions of the substrate, the dielectric structure including first and second pedestals extending below the first and second transistor structures, the first pedestal adjacent the first portion of the substrate, the second pedestal adjacent the second portion of the substrate, a third portion of the substrate between the first and second pedestals.

In one or more second embodiments, further to the first embodiments, the first pedestal has a first width between the first and third portions of the substrate, the second pedestal has the first width between the second and third portions of the substrate, and the first width is approximately equal to a length of a gate electrode adjacent the first metallization structure, the first metallization structure between the gate electrode and the dielectric structure.

In one or more third embodiments, further to the first or second embodiments, the gate electrode is a first gate electrode, a second gate electrode is adjacent the first gate electrode, the first gate electrode between the second gate electrode and the dielectric structure, and the third portion of the substrate has a second width approximately equal to a distance between the first and second gate electrodes.

In one or more fourth embodiments, further to the first through third embodiments, the third portion of the substrate has a height approximately equal to a depth of the first pedestal.

In one or more fifth embodiments, further to the first through fourth embodiments, one or more first dielectric layers are between the dielectric structure and a first sidewall of the first metallization structure, one or more second dielectric layers are between the dielectric structure and a second sidewall of the second metallization structure, the dielectric structure has a third width between the one or more first dielectric layers and the one or more second dielectric layers, the third width in a direction, a first gate electrode adjacent the first metallization structure has a length in the direction, a distance in the direction separates the first gate electrode and a second gate electrode adjacent the first gate electrode, the first gate electrode between the second gate electrode and the dielectric structure, and the third width is approximately equal to a sum of the distance and twice the length.

In one or more sixth embodiments, further to the first through fifth embodiments, a first gate electrode is adjacent the first metallization structure, the first metallization structure between the first gate electrode and the dielectric structure, a second gate electrode is adjacent the first gate electrode, the first gate electrode between the second gate electrode and the dielectric structure, the first and second gate electrodes are separated by a distance in a direction, and the first gate electrode and the dielectric structure are separated by the distance in the direction.

In one or more seventh embodiments, further to the first through sixth embodiments, the direction is a first direction, and the dielectric structure has a fourth width in a second direction, the fourth width approximately equal to the distance, the second direction orthogonal to the first direction.

In one or more eighth embodiments, further to the first through seventh embodiments, the dielectric structure includes silicon and nitrogen.

In one or more ninth embodiments, further to the first through eighth embodiments, the first metallization structure couples the first source or drain body in the first transistor structure with a third source or drain body in a third transistor structure, and one or more dielectric layers are between the dielectric structure and a first sidewall of the first metallization structure.

In one or more tenth embodiments, further to the first through ninth embodiments, no first section of the first metallization structure overhangs any second section of the dielectric structure.

In one or more eleventh embodiments, an apparatus includes a first source or drain contact in a first transistor structure over a substrate, a second source or drain contact in a second transistor structure over the substrate, and a dielectric structure between the first and second source or drain contacts and between first and second portions of the substrate and over a third portion of the substrate, the dielectric structure including first and second feet extending into the substrate, the first foot between the first and third portions of the substrate, the second foot between the second and third portions of the substrate.

In one or more twelfth embodiments, further to the eleventh embodiments, the first foot has a first width between the first and third portions of the substrate, the second foot has the first width between the second and third portions of the substrate, and the first width is approximately equal to a length of a gate electrode adjacent the first source or drain contact, the first source or drain contact between the gate electrode and the dielectric structure.

In one or more thirteenth embodiments, further to the eleventh or twelfth embodiments, the gate electrode is a first gate electrode, a second gate electrode is adjacent the first gate electrode, the first gate electrode between the second gate electrode and the dielectric structure, and the third portion of the substrate has a second width approximately equal to a distance between the first and second gate electrodes.

In one or more fourteenth embodiments, further to the eleventh through thirteenth embodiments, the apparatus is coupled to a host component, and the apparatus is coupled to a power supply through the host component.

In one or more fifteenth embodiments, a method includes recessing first and second source or drain contacts over a substrate, first and second gate electrodes between the first and second source or drain contacts, a source or drain trench between the first and second gate electrodes, depositing a first mask material over the recessed first and second source or drain contacts, patterning a second mask material over the substrate, an opening in the second mask material over the first and second gate electrodes, the source or drain trench, and first and second sections of the first mask material, etching the opening through the first and second gate electrodes and the source or drain trench, and depositing a dielectric material in the opening.

In one or more sixteenth embodiments, further to the fifteenth embodiments, the etching the opening through the first and second gate electrodes and the source or drain trench anisotropically etches the opening in the substrate, the opening including first and second portions, the substrate including a third portion between the first and second portions, the first and second portions of the opening each having a width approximately equal to a length of the first gate electrode, and the depositing the dielectric material in the opening forms a dielectric structure over the substrate and between the first and second source or drain contacts, the dielectric structure including first and second pedestals, the first and second pedestals each having the width, the third portion of the substrate between the first and second pedestals.

In one or more seventeenth embodiments, further to the fifteenth or sixteenth embodiments, the depositing the dielectric material in the opening deposits a first dielectric material in the opening, and the method also includes selectively removing an exposed second dielectric material in the opening over the first and second gate electrodes and the source or drain trench.

In one or more eighteenth embodiments, further to the fifteenth through seventeenth embodiments, the first dielectric material deposited in the opening has a same composition as the second dielectric material over the first and second gate electrodes and the source or drain trench.

In one or more nineteenth embodiments, further to the fifteenth through eighteenth embodiments, the dielectric material includes silicon and nitrogen.

In one or more twentieth embodiments, further to the fifteenth through nineteenth embodiments, the first mask material includes silicon and carbon.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An apparatus, comprising:
a first metallization structure on a first source or drain body in a first transistor structure over a substrate;
a second metallization structure on a second source or drain body in a second transistor structure over the substrate; and
a dielectric structure between the first and second metallization structures and between first and second portions of the substrate, the dielectric structure comprising first and second pedestals extending below the first and second transistor structures, the first pedestal adjacent the first portion of the substrate, the second pedestal adjacent the second portion of the substrate, and a third portion of the substrate between the first and second pedestals.

2. The apparatus of claim 1, wherein:
the first pedestal has a first width between the first and third portions of the substrate;
the second pedestal has the first width between the second and third portions of the substrate; and
the first width is approximately equal to a length of a gate electrode adjacent the first metallization structure, the first metallization structure between the gate electrode and the dielectric structure.

3. The apparatus of claim 2, wherein:
the gate electrode is a first gate electrode;
a second gate electrode is adjacent the first gate electrode, the first gate electrode between the second gate electrode and the dielectric structure; and
the third portion of the substrate has a second width approximately equal to a distance between the first and second gate electrodes.

4. The apparatus of any of claims 1 to 3, wherein the third portion of the substrate has a height approximately equal to a depth of the first pedestal.

5. The apparatus of any of claims 1 to 4, wherein:
one or more first dielectric layers are between the dielectric structure and a first sidewall of the first metallization structure;
one or more second dielectric layers are between the dielectric structure and a second sidewall of the second metallization structure;
the dielectric structure has a third width between the one or more first dielectric layers and the one or more second dielectric layers, the third width in a direction;
a first gate electrode adjacent the first metallization structure has a length in the direction;
a distance in the direction separates the first gate electrode and a second gate electrode adjacent the first gate electrode, the first gate electrode between the second gate electrode and the dielectric structure; and
the third width is approximately equal to a sum of the distance and twice the length.

6. The apparatus of any of claims 1 to 5, wherein:
a first gate electrode is adjacent the first metallization structure, the first metallization structure between the first gate electrode and the dielectric structure;
a second gate electrode is adjacent the first gate electrode, the first gate electrode between the second gate electrode and the dielectric structure;
the first and second gate electrodes are separated by a distance in a direction; and
the first gate electrode and the dielectric structure are separated by the distance in the direction.

7. The apparatus of claim 6, wherein:
the direction is a first direction; and
the dielectric structure has a fourth width in a second direction, the fourth width approximately equal to the distance, the second direction orthogonal to the first direction.

8. The apparatus of any of claims 1 to 7, wherein the dielectric structure comprises silicon and nitrogen.

9. The apparatus of any of claims 1 to 8, wherein:
the first metallization structure couples the first source or drain body in the first transistor structure with a third source or drain body in a third transistor structure; and
one or more dielectric layers are between the dielectric structure and a first sidewall of the first metallization structure.

10. The apparatus of claim 9, wherein no first section of the first metallization structure overhangs any second section of the dielectric structure.

11. A method, comprising:
recessing first and second source or drain contacts over a substrate, first and second gate electrodes between the first and second source or drain contacts, a source or drain trench between the first and second gate electrodes;
depositing a first mask material over the recessed first and second source or drain contacts;
patterning a second mask material over the substrate, an opening in the second mask material over the first and second gate electrodes, the source or drain trench, and first and second sections of the first mask material;
etching the opening through the first and second gate electrodes and the source or drain trench; and
depositing a dielectric material in the opening.

12. The method of claim 11, wherein:
the etching the opening through the first and second gate electrodes and the source or drain trench anisotropically etches the opening in the substrate, the opening comprising first and second portions, the substrate comprising a third portion between the first and second portions, the first and second portions of the opening each having a width approximately equal to a length of the first gate electrode; and
the depositing the dielectric material in the opening forms a dielectric structure over the substrate and between the first and second source or drain contacts, the dielectric structure comprising first and second pedestals, the first and second pedestals each having the width, the third portion of the substrate between the first and second pedestals.

13. The method of claim 11 or 12, wherein the depositing the dielectric material in the opening deposits a first dielectric material in the opening, further comprising selectively removing an exposed second dielectric material in the opening over the first and second gate electrodes and the source or drain trench.

14. The method of claim 13, wherein the first dielectric material deposited in the opening has a same composition as the second dielectric material over the first and second gate electrodes and the source or drain trench.

15. The method of any of claims 11 to 14, wherein the dielectric material comprises silicon and nitrogen and/ or the first mask material comprises silicon and carbon.
